# EUROPEAN PATENT SPECIFICATION

(11) **EP 2 128 192 B1**
(45) Date of publication and mention of the grant of the patent: **12.10.2011**
(21) Application number: 09007229.9
(22) Date of filing: 29.05.2009
(51) Int. Cl.: C08J 7/04, H01L 51/50, H01L 51/52, H05B 33/04

(54) **Barrier laminate, gas barrier film and device using the same**
Sperrschichtlaminat, Gassperrfolie und Vorrichtung damit
Stratifié de barrière, film à barrière contre les gaz et dispositif l'utilisant

(30) Priority: 29.05.2008 JP 2008140983
(43) Date of publication of application: 02.12.2009
(73) Proprietor: FUJIFILM Corporation, Tokyo 106-0031 (JP)
(72) Inventor: Tsukahara, Jiro, Ashigarakami-gun Kanagawa 258-8577 (JP); Ito, Shigehide, Ashigarakami-gun Kanagawa 258-8577 (JP)
(74) Representative: HOFFMANN EITLE

(56) References cited:
- WO-A1-2007/123006
- JP-A- 2006 321 127
- US-A1- 2006 275 616
- US-B1- 6 413 645

## Description

### Field of the invention

The present invention relates to a barrier laminate, a gas barrier film and a device using the barrier laminate, or the gas barrier film.

### Description of the related art

Heretofore, a gas barrier film in which a thin film comprising a metal oxide such as aluminum oxide, magnesium oxide and silicon oxide is formed on a surface of a plastic film is widely used for a package of articles which requires to be shut out from various gases such as vapor and oxygen and for a package to prevent industrial goods, medical products and the like from changing in their qualities.

In the recent years, in the field of a liquid crystal display device and an organic EL device, plastic film substrates start to replace glass substrates, which are heavy and easily broken. Since such plastic film substrates are applicable to a Roll to Roll system, its cost is advantageous. However, such plastic film substrates have a problem in that the plastic film substrate is poorer in moisture vapor barrier property than glass substrates. Therefore, when the plastic film is used for a liquid crystal display device, moisture vapor infiltrate into the liquid crystal cell, causing its display failure.

In order to solve this problem, US Patent No. 6, 413, 045 discloses the technique realizing less than 0.005 g/m²/day of the vapor permeability by using an alternate layer structure comprising several organic layers and inorganic layers as a barrier layer. The specification discloses that, when only one organic layer and one inorganic layer are laminated, its vapor permeability is 0.011 g/m²/day, and that the multi-layers laminate is technically valuable.

JP-A-2006 321127 discloses a barrier film comprising an inorganic layer, an organic layer and a glue layer between the inorganic and organic layers. The organic layer comprises a cyclic compound which contains nitrogen, sulfur or oxygen, and the glue layer comprises a silane coupling agent

WO-A-2007/123006 discloses a gas barrier film comprising a resin film substrate, two ceramic layers, a stress relaxation layer between the ceramic layers, and a smoothing layer formed from a polymerizable inorganic compound on the outermost ceramic layer. The stress relaxation layer contains a polymer (e.g. a silicon polymer).

US-A-2006/275616 discloses an article comprising an inorganic layer, a silane coupling agent layer comprising a vinylsilane and an aminosilane, and a benzocyclobutene-based resin on the silane coupling agent layer.

### Summary of the invention

However, since multi-layers laminate of organic layers and inorganic layers such as described in US Patent No. 6, 413, 645 lowers its productivity, it may become a major problem when the gas barrier film is supplied in a large amount in view of the industrial availability. In order to produce the gas barrier film in low cost, it is required that the gas barrier film expresses high barrier property in as small number of layers as possible. From those, it is desired to develop an organic inorganic laminate which achieves not more than 0.005 g/m²/day of the vapor permeability, especially less than 0.001 g/m²/day, even if the laminate has only one combination of one organic layer and one inorganic layer, a gas barrier film having the organic inorganic laminate, and an organic EL device having the gas barrier film.

The object of the present intention is to solve the above problem, and to provide a gas barrier laminate having high barrier property.

Given the situation as above, the present inventor has assiduously studied and has found that, by using a layer formed by curing a polymerizing compound having three groups, which are an ethylenic double bond, an aromatic group and a group capable of causing a silane coupling reaction, the organic layer in forming of an inorganic layer is hard to be damaged. Thereby, on the organic layer, a dense inorganic layer is formed. And the problem is solved. Further, the inventor found that, by providing an inorganic layer on a surface of the organic layer, the adhesiveness between the organic layer and the inorganic layer is improved, and the barrier property is enhanced.

Specifically, the aforementioned problem can be solved by the following means.
[1] A barrier laminate comprising at least one organic layer and at least one inorganic layer wherein the organic layer is obtainable by curing a composition comprising a (meth)acrylate compound and a polymerizable compound represented by the following Formula (I): 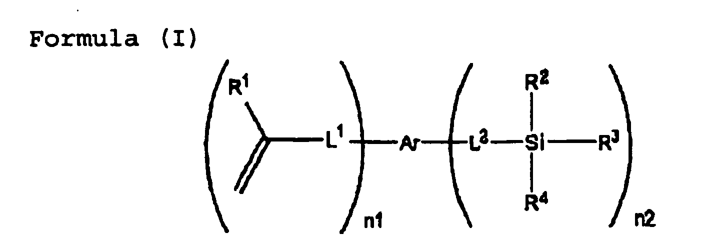 wherein Ar represents an optionally substituted aromatic group, R¹ represents a hydrogen atom, an alkyl group, a halogen atom, an alkoxy group, or an acyloxy group, L¹ and L² each represents an optionally substituted divalent linking group, R² and R³ each represents an alkoxy group, an acyloxy group, a halogen atom, or an amino group, R⁴ represents an alkyl group, an aryl group, an alkoxy group, an acyloxy group, a halogen atom or an amino group, and n1 and n2 each represents an integer of 1 to 5; or one of the following polymerizable compounds: 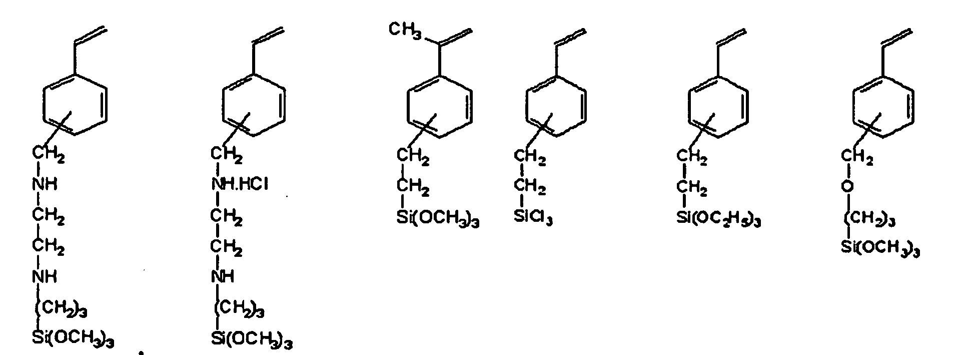 and
   the weight of carbon atoms composing a cyclic carbon structure in the polymerizable compounds in the curable composition is ≥20% of the weight of polymerizable compounds in the curable composition.
[4] A barrier laminate according to [1], wherein Ar is a phenylene group or a naphthalene group, L¹ and L² each represents an alkylene group, an arylene group, an ether group, an imino group, a carbonyl group, a sulfonyl group, or a bivalent residue formed by bonding a plurality thereof in series, and n1 and n2 are each 1 or 2.
[5] A barrier laminate according to any of [1] or [4], wherein the inorganic layer is on a surface of the organic layer.
[6] A barrier laminate according to any of [1] to [5], wherein the inorganic layer comprises a metal oxide, a metal nitride, a metal carbide, a metal oxide-nitride, or a metal oxide-carbide.
[7] A barrier laminate according to [6], wherein the inorganic layer comprises a metal oxide, a metal nitride, or a metal oxide-nitride.
[8] A barrier laminate according to any of [1] to [7], wherein the inorganic layer comprises oxides comprising at least one of silicon and aluminium.
[9] A barrier laminate according to any of [1] to [8], wherein the laminate comprises one of the organic layer and one of the inorganic layer.
[10] A barrier laminate according to any of [1] to [3], wherein the laminate comprises at least two of the organic layer and at least two of the inorganic layer laminated alternately.
[11] A gas barrier film comprising a barrier laminate according to any of [1] to [10].
[12] A device comprising a barrier laminate according to any of [1] to [10].
[13] A device according to [12], wherein the device comprises a barrier film substrate which comprises the barrier laminate on a substrate film.
[14] A device according to [12] or [13], wherein the device is sealed with the barrier laminate or the barrier film substrate.
[15] A device according to any of [12] to [14], wherein the device is an electronic device.
[15] A device according to any of [12] to [14], wherein the device is an organic electroluminescent device.

### Description of Specific Embodiments

The contents of the present invention are described in detail hereinunder. In this description, the numerical range expressed by the wording "a number to another number" means the range that falls between the former number indicating the lowermost limit of the range and the latter number indicating the uppermost limit thereof. "Organic EL device" as referred to herein means an organic electroluminescent device. In addition, "(meth) acrylate" means acrylate and methacrylate in the present specification.

### <Barrier laminate>

The gas barrier laminate of the present invention is characterized in that it has at least one organic layer and at least one inorganic layer, wherein the organic layer is formed by curing a polymerizable compound having an ethylenic double bond, an aromatic group and a group capable of causing a silane coupling reaction (hereinafter, sometimes referred to as polymerizable aromatic silane coupling agent). By using such an organic layer, the barrier property of the barrier film is enhanced. According to the study of the inventor, it is presumed that the organic layer can be formed by a polymerizable composition comprising a polymerizable aromatic silane coupling agent is hard to be damaged, and, as a result, a dense inorganic layer is formed on the organic layer, thereby enhancing both of its barrier property and adhesiveness. It is important for the polymerizable aromatic silane coupling agent to have an ethylenic double bond, an aromatic group and a group capable of causing a silane coupling reaction. When a polymerizable silane coupling agent not having an aromatic group is used, its adhesiveness is improved, however, the barrier property is not improved. This is clearly shown in the Example later.

The barrier laminate of the present invention has preferably a structure which comprises an inorganic layer formed on a surface of the organic layer, more preferably a' structure which comprises an alternate laminate of at least two of the above organic layers and at least two of the inorganic layers. Such the structure improves the adhesiveness between the organic layer and the inorganic layer, and enhances the barrier property of the barrier laminate.

### (Organic layer)

At least one of an organic layer of the present invention is the organic layer formed by polymerizing the polymerizable aromatic silane coupling agent.

The aromatic group may be an aromatic hydrocarbon group or an aromatic heterocyclic group, and preferred is an aromatic hydrocarbon group. The aromatic hydrocarbon group is preferably a multivalent aromatic hydrocarbon group obtainable by removing several hydrogen atoms from an aromatic hydrocarbon, more preferably a multivalent aromatic hydrocarbon group obtainable by removing two hydrogen atoms from an aromatic hydrocarbon, still more preferably a phenylene group and a naphthalene group, even more preferably a phenylene group.

The ratio of a weight of carbon atoms composing the cyclic carbon structure in the polymerizable aromatic silane coupling agent of the present invention is preferably 20% by weight, more preferably 25 to 50% by weight. By setting such a range, the organic layer has a highly smooth surface, and higher barrier property is exerted by lamination of an inorganic layer thereon. Two or more kinds of polymerizable aromatic silane coupling agents may be contained.

The polymerizable aromatic silane coupling agent is represented by the following formula (1): 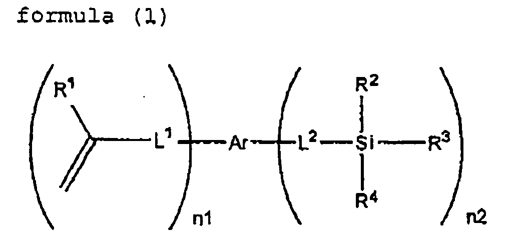 wherein Ar represents an aromatic group, R¹ represents a hydrogen atom, an alkyl group, an halogen atom, an alkoxy group, or an acyloxy group, L¹ and L² each represent a divalent linking group, R² and R³ each represent an alkoxy group, an acyloxy group, a halogen atom, or an amino group, R⁴ represent an alkyl group, an aryl group, an alkoxy group, an acyloxy group, a halogen atom, or an amino group, and n1 and n2 each are an integer 1 to 5.

Ar is preferably a multivalent aromatic hydrocarbon group obtained by removing several hydrogen atoms from an aromatic hydrocarbon, more preferably an arylene group obtained by removing two hydrogen atoms from an aromatic hydrocarbon, still more preferably a phenylene group, or a naphthalene group, most preferably a phenylene group. Ar may have a substituent group. Examples of the substituent group which substitutes Ar include an alkyl group (for example, methyl group, ethyl group, isopropyl group, t-butyl group, n-octyl group, n-decyl group, n-hexadecyl group, cyclopropyl group, cyclopentyl group, cyclohexyl group), an alkenyl group (for example, vinyl group, aryl group, 2-butenyl group, 3-pentenyl group), an aryl group (for example, phenyl group, p-methylphenyl, naphthyl group, anthryl group, phenanthryl group, pyrenyl group), a halogen atom (for example, fluorine atom, chlorine atom, bromine atom, iodine atom), an acyl group (for example, acetyl group, benzoyl group, formyl group, pivaloyl group), an alkoxycarbonyl group (for example, methoxycarbonyl group, ethoxycarbonyl group), an aryloxycarbonyl group (for example, phenyloxycarbonyl group), a sulfinyl group (methanesulfinyl group, benzenesulfinyl group), a heterocyclic group (it preferably has 1 to 12 carbon atoms, includes a nitrogen atom, an oxygen atom, or a sulfur atom as a hetero atom, and may be an aliphatic heterocyclic group, or a heteroaryl group, and examples thereof include imidazolyl group, pyridyl group, quinolyl group, furyl group, thienyl group, piperidyl group, morpholino group, benzoxazolyl group, benzimidazolyl group, benzothiazolyl group, carbazolyl group, azepinyl group). Those substituent groups may be further substituted.

Concerning R¹, the alkyl group is preferably a methyl group, the halogen atom is preferably a chlorine atom, the alkoxy group is preferably a methoxy group and an ethoxy group, the acyloxy group is preferably an acetoxy group, or a benzoyloxy group. Of those, R¹ is more preferably a hydrogen atom, or a methyl group.

L¹ and L² represent a divalent linking group, and the examples of the divalent linking group include an alkylene group (for example, 1, 3-propylene group, 2, 2-dimethyl-1, 3-propylene group, 2-buthyl-2-ethyl-1, 3-propylene group, 1, 6-hexylene group, 1, 9-nonylene group, 1,12-dodecylene group, 1, 16-hexdecylene), an arylene group (for example, phenylene group and naphthalene group), an ether group, an imino group, a carbonyl group, a sulfonyl group, and a divalent residue formed by serially bonding plurality of those divalent linking groups (for example, polyethyleneoxy group, polypropyleneoxy group, propynyloxyethylene group, butyloyloxypropylene group, caproyloxyethylene group, caproyloxybutylene group, 2, 2-propilenephenylene group). Of those, preferred are an alkylene group,' and an arylene group. L¹ and L² may have a substituent group. Examples of the substituent group which substitutes L¹ and L² include an alkyl group (for example, methyl group, ethyl group, isopropyl group, t-butyl group, n-octyl group, n-decyl group, n-hexadecyl group, cyclopropyl group, cyclopentyl group, cyclohexyl group), an alkenyl group(for example, vinyl group, allyl group, 2-butenyl group, 3-pentenyl group), an aryl group (for example, phenyl group, p-methylphenyl group, naphthyl group, anthryl group, phenanthryl group and pyrenyl group), a halogen atom (for example, fluorine atom, chlorine atom, bromine atom and iodine atom), an acyl group (for example, acetylene group, benzoyl group, formyl group, pivaloyl group), an alkoxycarbonyl group (for example, methoxycarbonyl group and ethoxycarbonyl group), an aryloxycarbonyl group (for example, phenyloxycarbonyl group), a sulfonyl group (for example, methanesulfonyl group and benzenesulfonyl group), a sulfinyl group (for example, methanesulfinyl group and benzenesulfinyl group), a heterocyclic group (it has preferably 1 to 12 carbon atoms, and contains a nitrogen atom, an oxygen atom, or a sulfur atom, and the like as a hetero atom, and may be an aliphatic heterocyclic group, or a heteroaryl group, and examples thereof include imidazolyl group, pyridyl group, quinolyl group, furyl group, thienyl group, piperidyl group, morpholino group, benzoxazolyl group, benzimidazolyl group, benzothiazolyl group, carbazolyl group, azepinyl group). Those substituent groups may be further substituted.

Concerning R² and R³, the alkoxy group is preferably a methoxy group and an ethoxy group, the acyloxy group is preferably an acetoxy group, the halogen atom is preferably a chlorine atom, and the amino group is preferably a dimethylamino group. Of those, preferred is an alkoxy group.

Concerning R⁴, the alkyl group is preferably a methyl group and an ethyl group, the aryl group is preferably phenyl group, the alkoxy group is preferably a methoxy group and an ethoxy group, the acyloxy group is preferably an acetoxy group, the halogen atom is preferably a chlorine atom, and the amino group is preferably a dimethylamino group. Of those, preferred are an alkoxy group and an alkyl group.

Concerning n1, 1 or 2 is preferred. Concerning n2, 1 or 2 is preferred.

Specific examples of the polymerizable aromatic silane coupling agent used in the present invention are shown below, however, which to the present invention is not limited. In the following exemplary compounds (1) and (3) to (7), a substituent group may bond to the aromatic group at any of ortho-position, para-position and meta-position, and preferred is at meta-position or para-position. Examples of the aromatic silane coupling agent in the present invention include compounds having two or more of the substituent groups.

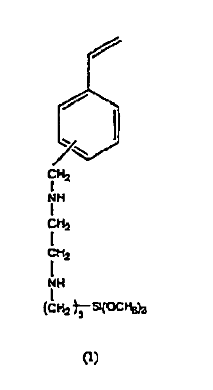

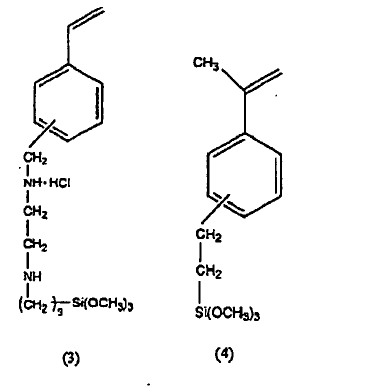

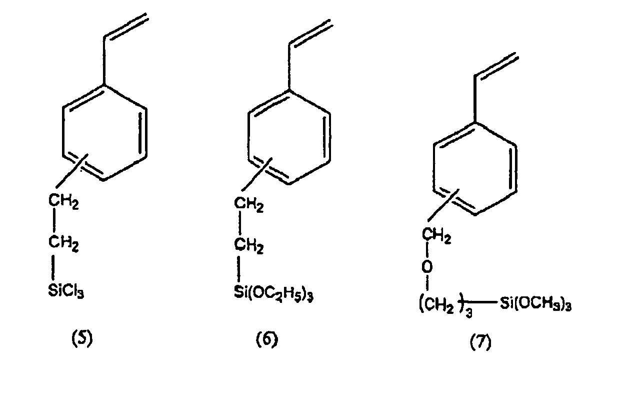

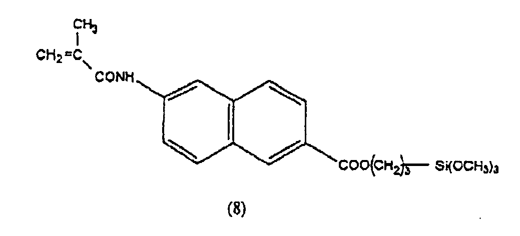

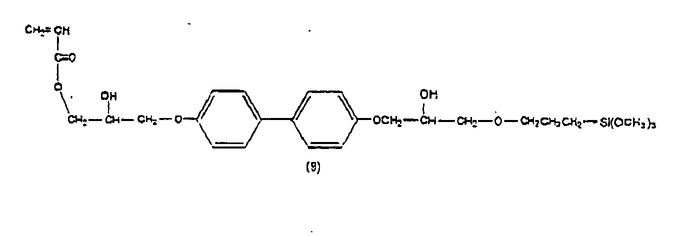

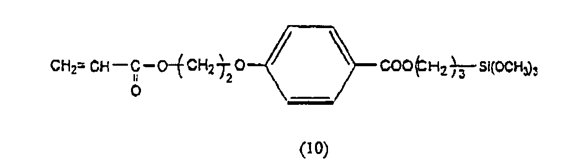

The organic layer of the present invention may be formed by using a polymerizable compound in addition to the polymerizable aromatic silane coupling agent, without deviating the gist of the present invention. As such a polymerizable compound, known compounds are widely used and a (meth)acrylate is preferably used. When the other polymerizable compound such as a (meth) acrylate is mixed with the polymerizable aromatic silane coupling compound, it is preferably mixed so that the ratio of weight of carbon atoms composing the cyclic carbon structure to a weight of the polymerizable compounds in the mixture is 20% by weight or more. By setting such a range, the organic layer having a highly smooth surface and higher barrier property is obtained in laminating an inorganic layer thereon.

### (Polymerization initiator)

The organic layer in the present invention is generally obtained by coating and curing a composition comprising a polymerizable compound such as the polymerizable aromatic silane coupling agent. In the present invention, the organic layer mainly comprising polymer is formed by irradiating the above polymerizable composition with hear or various energy lines, and polymerizing and cross-linking it. Examples of the energy lines include ultraviolet ray, visible ray, infrared ray, electron ray, X-ray, gamma ray. In polymerization by heat, heat polymerization initiator is used. In polymerization by ultraviolet ray, photo polymerization initiator is used. In polymerization by visible ray, photo polymerization initiator and radiosensitizing agent are used. Of those, it is preferred to subject a polymerizable composition comprising a photo polymerization initiator to polymerization and cross-link by ultraviolet ray.

In the case where a photopolymerization initiator is used, its amount is preferably at least 0.1 mol% of the total amount of the polymerizing compound, more preferably from 0.5 to 2 mol%. By setting the thus-designed composition, polymerization reaction though an active ingredient forming reaction may be suitably controlled. Examples of the photopolymerization initiator include Ciba Speciality Chemicals' commercial products, Irgacure series (e.g., Irgacure 651, Irgacure 754, Irgacure 184, Irgacure 2959, Irgacure 907, Irgacure 369, Irgacure 379, Irgacure 819), Darocure series (e.g., Darocure TPO, Darocure 1173), Quantacure PDO; Lamberti's commercial products, Ezacure series (e.g., Ezacure TZM, Ezacure TZT, Ezacure KTO46), etc.

### (Method of formation of organic layer)

The method for forming the organic layer is not specifically defined. For example, the layer may be formed according to a solution coating method or a vacuum film formation method. The solution coating method is, for example, a dipping method, an air knife coating method, a curtain coating method, a roller coating method, a wire bar coating method, a gravure coating method, a slide coating method, or an extrusion coating method using a hopper as in USP 2681294. The vacuum film formation method is not specifically defined, but is preferably a film formation method by vapor deposition or plasma CVD. In the present invention, the polymer may be applied for coating as its solution, or a hybrid coating method along with an inorganic material, as in JP-A 2000-323273 and 2004-25732, may also be used.

In the present invention, the composition comprising a polymerizable monomer such as the polymerizable aromatic silane coupling agent is cured by irradiation. The light for irradiation is generally a UV ray from a high-pressure mercury lamp or low-pressure mercury lamp. The radiation energy is preferably at least 0.1 J/cm², more preferably at least 0.5 J/cm². When the polymerizable aromatic silane coupling agent is (meth)acrylate series compounds, it may suffer from interference in polymerization owing to oxygen in air, and therefore, in their polymerization, the oxygen concentration or the oxygen partial pressure is preferably lowered. In the case where the oxygen concentration in polymerization is lowered according to a nitrogen purging method, the oxygen concentration is preferably not more than 2%, more preferably not more than 0.5%. In the case where the oxygen partial pressure in polymerization is lowered by a pressure reduction method, the whole pressure is preferably not more than 1000 Pa, more preferably not more than 100 Pa. Especially preferred is UV polymerization with at least 0.5 J/cm² energy radiation under a condition of reduced pressure of not more than 100 Pa.

The organic layer is preferably smooth and has high membrane strength. The mean roughness (Ra) of 1 µm² of the organic layer is preferably not more than 1 nm, more preferably not more than 0.5 nm. Preferably, the rate of polymerization of monomer is at least 85%, more preferably at least 88%, even more preferably at least 90%, still more preferably at least 92%. The rate of polymerization as referred to herein means the ratio of the reacted polymerizable group to all the polymerizing group (acryloyl group and methacryloyl group) in the monomer mixture. The rate of polymerization may be quantitatively determined according to IR absorptiometry.

The thickness of the organic layer is not specifically defined. However, when the layer is too thin, then its thickness could hardly keep uniformity; but when too thick, the layer may be cracked by external force applied thereto and its barrier property may lower. From these viewpoints, the thickness of the organic layer is preferably from 50 nm to 2000 nm, more preferably from 200 nm to 1500 nm.

As so mentioned in the above, the organic layer is preferably smooth. The mean roughness (Ra) of 1 µm² is preferably not more than 1 nm, more preferably not more than 0.5 nm. The surface of the organic layer is required not to have impurities and projections such as particles. Accordingly, it is desirable that the organic layer is formed in a clean room. The degree of cleanness is preferably not more than class 10000, more preferably not more than class 1000.

Preferably, the hardness of the organic layer is higher. It is known that, when the hardness of the organic layer is high, then the inorganic layer may be formed smoothly and, as a result, the barrier level of the gas barrier film is thereby improved. The hardness of the organic layer may be expressed as icrohardness based on a nano-indentation method. The microhardness of the organic layer is preferably at least 150 N/mm, more preferably at least 180 N/mm, still more preferably at least 200 N/mm.

Two or more organic layers are preferably laminated. In this case, as long as at least one organic layer is the organic layer derived from the above polymerizable aromatic silane coupling agent, other organic layers may be the organic layer derived from the polymerizable aromatic silane coupling agent, or may be an organic layer derived from other composition. One of the other organic layers may be a layer having a composition continuously changing in the direction of the layer thickness with no definite interface between an organic layer and an inorganic layer, as illustrated in USP-A 2004-46497.

### (Inorganic Layer)

The inorganic layer is, in general, a layer of a thin film formed of a metal compound. For forming the inorganic layer, employable is any method capable of producing the intended thin film. For it, for example, suitable are physical vapor deposition methods (PVD) such as vapor evaporation method, sputtering method, ion plating method; various chemical vapor deposition methods (CVD); liquid phase growth methods such as plating or sol-gel method. In the present invention, even if formed by sputtering method, the high barrier property is kept. Not specifically defined, the component to be in the inorganic layer may be any one satisfies the above-mentioned requirements. For example, it includes metal oxides, metal nitrides, metal carbides, metal oxide-nitrides, or metal oxide-carbides. Preferably used are oxides, nitrides, carbide oxide-nitrides, or oxide-carbides comprising at least one metal selected from Si, Al, In, Sn, Zn, Ti, Cu, Ce and Ta. Of those, preferred are oxides, nitrides carbide oxide-nitrides, or oxide-carbides of a metal selected from Si, Al, In, Sn, Zn and Ti; more preferred are metal oxides, nitrides or oxide-nitrides with Si or Al. These may contain any other element as a subsidiary component. The present invention is advantageous from viewpoints that a barrier laminate having high barrier property is obtained even if a metal oxide is used as a material of the inorganic layer which is produced through plasma process. In the present invention, preferred especially is a silicon oxide, an aluminium oxide, or a mixed oxide of silicon and aluminium. By utilizing those inorganic materials, the adhesiveness between the organic layer and the inorganic layer is more enhanced.

Preferably, the surface smoothness of the inorganic layer formed in the present invention is less than 1 nm in terms of the mean roughness (Ra value) in 1 µm square, more preferably not more than 0.5 nm. Accordingly, it is desirable that the inorganic layer is formed in a clean room. Preferably, the degree of cleanness is not more than class 10000, more preferably not more than class 1000.

Not specifically defined, the thickness of the inorganic layer is generally within a range of from 5 to 500 nm/layer, preferably from 20 to 200 nm/layer. Two or more inorganic layers may be laminated. In the present invention, the embodiment in which two or more inorganic layers are provided improves the adhesiveness between the layers and may reduce the failure rate when it is used in an electric device. When not more than two layers are provided, the individual layers may have the same composition or different compositions. In case where two or more layers are laminated, it is desirable that the individual inorganic layers are so designed as to fall within the above-mentioned preferred ranges. In addition, as so mentioned hereinabove and as disclosed in UP Laid-Open 2004-46497, the inorganic layers may be gradation layers of which the composition changes continuously in the thickness direction of the layer, with no definite boundary to the adjacent inorganic layer.

### (Lamination of Organic Layer and Inorganic Layer)

The organic layer and the inorganic layer may be laminated by repeated film formation to form the organic layer and the inorganic layer in a desired layer constitution. In case where the inorganic layer is formed according to a vacuum film formation method such as sputtering method, vacuum evaporation method, ion plating method or plasma CVD method, then it is desirable that the organic layer is also formed according to a vacuum film formation method such as the above-mentioned flash vapor deposition method. While the barrier layer is formed, it is especially desirable that the organic layer and the inorganic layer are laminated all the time in a vacuum of not more than 1000 Pa, not restoring the pressure to an atmospheric pressure during the film formation. More preferably, the pressure is not more than 100 Pa, even more preferably not more than 50 Pa, still more preferably not more than 20 Pa.

Especially, in the case where at least two of the organic layers and at least of the inorganic layers are laminated alternately in the present invention, its high barrier property is exerted. Further, it is preferred that the inorganic layer is formed on a surface of the organic layer derived from the polymerizable aromatic silane coupling agent, because the adhesiveness between the organic layer and the inorganic layer is enhanced.

### (Functional Layer)

The device of the present invention may have a functional layer on the barrier laminate or in any other position. The functional layer is described in detail in JP-A 2006-289627, paragraphs 0036 to 0038. Examples of other functional layers than those are a matting agent layer, a protective layer, an antistatic layer, a planarizing layer, an adhesiveness improving layer, a light shielding layer, an antireflection layer, a hard coat layer, a stress relaxing layer, an antifogging layer, an anti-soiling layer, a printable layer, an easy adhesive layer, etc.

### (Use of Barrier Laminate)

In general, the barrier laminate of the present invention is formed on a support. Selecting the support, the barrier laminate may have various applications. The support includes a substrate film, as well as various devices, optical members, etc. Concretely, the barrier laminate of the present invention may be used as a barrier layer of a gas barrier film. The barrier laminate and the gas barrier film of the present invention may be used for sealing up devices that require barrier performance. The barrier laminate and the gas barrier film of the present invention may apply optical members. These are described in detail hereinunder.

### <Gas barrier film>

The gas barrier film comprises a substrate film and a barrier laminate formed on the substrate film. In the gas barrier film, the barrier laminate of the present invention may be provided only one surface of the substrate film, or may be provided on both surfaces thereof. The barrier laminate of the present invention may be laminated in an order of an inorganic layer and an organic layer from the side of the substrate film; or may be laminated in an order of an organic layer and an inorganic layer from it. The uppermost layer of the laminate of the present invention may be an inorganic layer or an organic layer.

The gas barrier film of the present invention is a film substrate having a barrier layer that functions to block oxygen, water, nitrogen oxide, sulfur oxide, ozone and others in air.

Not specifically defined, the number of the layers that constitute the gas barrier film may be typically from 2 layers to 30 layers, more preferably from 3 layers to 20 layers.

The gas barrier film may have any other constitutive components (e.g., functional layers such as adhesive layer) in addition to the barrier laminate and the substrate film. The functional layer may be disposed on the barrier laminate, or between the barrier laminate and the substrate film, or on the side (back) of the substrate film not coated with the barrier laminate.

### (Plastic Film)

In the gas barrier film of the present invention, the substrate film is generally a plastic film. Not specifically defined in point of the material and the thickness thereof, the plastic film usable herein may be any one capable of supporting a laminate of an organic layer and an inorganic layer; and it may be suitably selected depending on the use and the object thereof. Concretely, the plastic film includes thermoplastic resins such as polyester resin, methacryl resin, methacrylic acid-maleic anhydride copolymer, polystyrene resin, transparent fluororesin, polyimide, fluoropolyimide resin, polyamide resin, polyamidimide resin, polyetherimide resin, cellulose acylate resin, polyurethane resin, polyether ether ketone resin, polycarbonate resin, alicyclic polyolefin resin, polyarylate resin, polyether sulfone resin, polysulfone resin, cycloolefin copolymer, fluorene ring-modified polycarbonate resin, alicyclic-modified polycarbonate resin, fluorene ring-modified polyester resin, acryloyl compound.

In case where the gas barrier film of the present invention is used as a substrate of a device such as an organic EL device to be mentioned hereinunder, it is desirable that the plastic film is formed of a heat-resistant material. Concretely, the plastic film is preferably formed of a heat-resistant transparent material having a glass transition temperature (Tg) of not lower than 100°C and/or a linear thermal expansion coefficient of not less than 40 ppm/°C. Tg and the linear expansion coefficient may be controlled by the additives to the material. The thermoplastic resin of the type includes, for example, polyethylene naphthalate (PEN: 120°C), polycarbonate (PC: 140°C), alicyclic polyolefin (e.g., Nippon Zeon's Zeonoa 1600: 160°C), polyarylate (PAr: 210°C), polyether sulfone (PES: 220°C), polysulfone (PSF: 190°C), cycloolefin copolymer (COC, compound described in JP-A 2001-150584: 162°C), polyimide (Mitsubishi gas chemical company's Neopulim : 260°C), fluorene ring-modified polycarbonate (BCF-PC, compound described in JP-A 2000-227603: 225°C), alicyclic-modified polycarbonate (IP-PC, compound described in JP-A 2000-227603: 205°C), acryloyl compound (compound described in JP-A 2002-80616: 300°C or more) (the parenthesized data are Tg). In particular, for high transparency, use of alicyclic polyolefin is preferred.

In the case where the gas barrier film of the present invention is used in combination with a polarizing plate, it is preferable that the gas barrier layer surface of the gas barrier film is faced at the inside of a cell and is disposed in the innermost (adjacent to the device). At that time, since the gas barrier film is disposed in the inside of the cell relative to the polarizing plate, a retardation value of the gas barrier film is important. As to a use form of the gas barrier film in such an embodiment, it is preferable that a barrier film using a base material film having a retardation value of not more than 10 nm and a circular polarizing plate ((quarter-wave plate) + (half-wave plate) + (linear polarizing plate)) are laminated and used, or that a linear polarizing plate is combined with a gas barrier film using a base material film having a retardation value of from 100 nm to 180 nm, which can be used as a quarter-wave plate, and used.

Examples of the base material film having a retardation of not more than 10 nm include cellulose triacetate (FUJITAC, manufactured by Fujifilm Corporation), polycarbonates (PURE-ACE, manufactured by Teijin Chemicals Ltd.; and ELMECH, manufactured by Kaneka Corporation), cycloolefin polymers (ARTON, manufactured by JSR Corporation; and ZEONOR, manufactured by Zeon Corporation), cycloolefin copolymers (APEL (pellet), manufactured by Mitsui Chemicals, Inc.; and TOPAS (pellet), manufactured by Polyplastics Co., Ltd.), polyarylates (U100 (pellet), manufactured by Unitika Ltd.) and transparent polyimides (NEOPULIM, manufactured by Mitsubishi Gas Chemical Company).

Also, films obtained by properly stretching the foregoing film to adjust it so as to have a desired retardation value can be used as the quarter-wave plate.

In view of the matter that the gas barrier film of the present invention is utilized as a device such as organic EL devices, the plastic film must be transparent, namely its light transmittance is usually not less than 80%, preferably not less than 85%, and more preferably not less than 90%. The light transmittance can be measured by a method described in JIS-K7105, namely by measuring a total light transmittance and an amount of scattered light using an integrating sphere type light transmittance analyzer and subtracting the diffuse transmittance from the total light transmittance.

Even in the case where the gas barrier film of the present invention is used for display use, for example, when it is not disposed on the side of an observer, the transparency is not always required. Accordingly, in such case, an opaque material can also be used as the plastic film. Examples of the opaque material include a known liquid crystal polymer such as polyimides and polyacrylonitrile.

The thickness of the plastic film to be used for the gas barrier film of the present invention is properly chosen depending upon the use and therefore, is not particularly limited. It is typically from 1 to 800 µm, and preferably from 10 to 200 µm. These plastic films may have a functional layer such as a transparent conductive layer and a primer layer. The functional layer is described in detail in paragraphs 0036 to 0038 of JP-A-2006-289627. Examples of functional layers other than these layers include a matting agent layer, a passivation layer, an antistatic layer, a smoothening layer, an adhesiveness improving layer, a light shielding layer, an antireflection layer, a hard coat layer, a stress relaxing layer, an antifogging layer, an antifouling layer, a layer to be printed and an easily adhesive layer.

### <Device>

The barrier laminate and the gas barrier film of the present invention are favorably used for devices that are deteriorated by the chemical components in air (e.g., oxygen, water, nitrogen oxide, sulfur oxide, ozone). Examples of the devices are, for example, organic EL devices, liquid-crystal display devices, thin-film transistors, touch panels, electronic papers, solar cells, other electronic devices. More preferred are organic EL devices.

The barrier laminate of the present invention may be used for film-sealing of devices. Specifically, this is a method of providing a barrier laminate of the present invention on the surface of a device serving as a support by itself. Before providing the barrier laminate, the device may be covered with a protective layer.

The gas barrier film of the present invention may be used as a substrate of a device or as a film for sealing up according to a solid sealing method. The solid sealing method comprises forming a protective layer on a device, then forming an adhesive layer and a gas barrier film as laminated thereon, and curling it. Not specifically defined, the adhesive may be a thermosetting epoxy resin, a photocurable acrylate resin, etc.

### (Organic EL Device)

Examples of an organic EL device with a gas barrier film are described in detail in JP-A 2007-30387.

### (Liquid-Crystal Display Device).

A reflection-type liquid-crystal display device has a constitution of a lower substrate, a reflection electrode, a lower alignment film, a liquid-crystal layer, an upper alignment film, a transparent electrode, an upper substrate, a λ/4 plate and a polarizing film, formed in that order from the bottom. In this, the gas barrier film of the present invention may be used as the transparent electrode substrate and the upper substrate. In color displays, it is desirable that a color filter layer is additionally provided between the reflection electrode and the lower alignment film, or between the upper alignment film and the transparent electrode. A transmission-type liquid-crystal display device has a constitution of a backlight, a polarizer, a λ/4 plate, a lower transparent electrode, a lower alignment film, a liquid-crystal layer, an upper alignment film, an upper transparent electrode, an upper substrate, a λ/4 plate and a polarizing film, formed in that order from the bottom. In this, the substrate of the present invention may be sued as the upper transparent electrode and the upper substrate. In color displays, it is desirable that a color filter layer is additionally provided between the lower transparent electrode and the lower alignment film, or between the upper alignment film and the transparent electrode. Not specifically defined, the type of the liquid-crystal cell is preferably a TN (twisted nematic) type, an STN (super-twisted nematic) type, a HAN (hybrid aligned nematic) type, a VA (vertically alignment) type, an ECB (electrically controlled birefringence) type, anOCB (optically compensatory bent) type, a CPA (continuous pinwheel alignment) type, or an IPS (in-plane switching) type.

### <Optical Member>

Examples of the optical member that comprises the barrier laminate of the present invention are a circular polarizer and the like.

### (Circular Polarizer)

Laminating a gas barrier film of the invention with a λ/4 plate and a polarizer gives a circular polarizer. In this case, the components are so laminated that the slow axis of the λ/4 plate could cross the absorption axis of the polarizer at an angle of 45°. The polarizer is preferably stretched in the direction of 45° from the machine direction (MD) thereof; and for example, those described in JP-A 2002-865554 are favorably used.

### (Solar Cell)

The barrier film substrate of the invention can be used also as a sealing film for solar cell devices. Preferably, the barrier film substrate of the invention is used for sealing a solar cell device in such a manner that its adhesive layer is on the side near to the solar cell device. The solar cell devices for which the barrier film substrate of the invention is favorably used are not specifically defined. For example, they include single crystal silicon-based solar cell devices, polycrystalline silicon-based solar cell devices, single-junction or tandem-structure amorphous silicon-based solar cell devices, gallium-arsenic (GaAs), indium-phosphorus (InP) or the like III-V Group compound semiconductor-based solar cell devices, cadmium-tellurium (CdTe) or the like II-VI Group compound semiconductor-based solar cell devices, copper/indium/selenium (CIS-based), copper/indium/gallium/selenium (CIGS-based), copper/indium/gallium/selenium/sulfur (CIGSS-based) or the like I-III-VI Group compound semiconductor-based solar cell devices, dye-sensitized solar cell devices, organic solar cell devices, etc. Above all, in the invention, the solar cell devices are preferably copper/indium/selenium (CIS-based), copper/indium/gallium/selenium (CIGS-based), copper/indium/gallium/selenium/sulfur (CIGSS-based) or the like I-III-VI Group compound semiconductor-based solar cell devices.

### (Others)

Other applications of the present invention are thin-film transistors as in JP-T 10-512104, touch panels as in JP-A 5-127822, 2002-48913, and electronic papers as in JP-A 2000-98326.

### EXAMPLES

The characteristics of the present invention are described more concretely with reference to the following Examples. Accordingly, the present invention should not be limitatively interpreted by the Examples mentioned below.

### Formation of a gas barrier film

40% of ethanol solution comprising a polymerizable monomer shown in the following Table (EB3702 means Ebecryl EB3702 manufactured by Daicel-cytec company Ltd.) and a polymerization initiator (Chiba Speciality Chemicals, IRGACURE907) was prepared using methyl ethyl ketone to form a film having a dry film thickness of 1000 nm on a substrate (manufactured by DuPont, Teonex Q65FA, having a thickness of 100 µm), and then cured through irradiation with UV rays at a dose of 0.5 J/cm² in atmosphere having 100 ppm of oxygen, thereby producing the organic layer. Aluminum oxide was deposited on the surface of the formed organic layer according to a vacuum sputtering method (reactive spptering) to form a film having thickness of 40 nm, thereby producing a gas barrier film. However, silicon oxide was deposited on the surface of the formed organic layer according to a vacuum sputtering method (reactive spptering) to form a film having thickness of 80 nm, thereby producing the gas barrier film of Sample No. 14. The obtained gas barrier films were tested and evaluated for the water vapor permeability and the adhesiveness according to the methods below.

### [Water Vapor Permeability]

The water vapor permeability (g/m²/day) were measured according to the method described in G. NISATO, P.C.P. BOUTEN, P.J. SLIKKERVEER, et al.; SID Conference Record of the International Display Research Conference 1435-1438. The measure was carried out at 40°C and 90% RH. The results are shown in below table.

### [Measurement for adhesiveness]

In order to evaluate the adhesiveness of the gas barrier film, cross-cut adhesiveness test compliant to JIS K5400 was carried out. The surface of the gas barrier films having the above construction was cut in at the entering angle of 90 degree toward the film surface at 1 mm interval, thereby producing one hundred of cross-cut at 1 mm interval. On the surface thereof, Mylar tape having the wide of 2 cm (manufactured by Nitto Denko, polyester tape, No. 31B) was attached, and then was peeled off using a tape peeling testing machine. The number (n) of the remaining grids which didn't peel off from one hundred of cross-cut on the laminated film was counted

**Table 1**

| Sample No. | E8-3702 | Compound (Example) | | Compound (Comparative Example) | | Barrier property | Adhesiveness | Remarks |
|---|---|---|---|---|---|---|---|---|
| | Content (weight %) | Species | Content (weight %) | Species | Content (weight %) | | | |
| 1 | 100 | no | no | - | - | 2×10⁻³ | 80 | Comp. |
| 2 | 90 | {1} | 10 | - | - | 9×10⁻⁴ | 100 | Example |
| 3 | 80 | {1} | 20 | - | - | 7×10⁻⁴ | 100 | Example |
| 4 | 70 | (1) | 30 | - | - | 6×10⁻⁴ | 100 | Example |
| 5 | 90 | (2) | 10 | - | - | 7×10⁻⁴ | 100 | Example |
| 6 | 80 | (2) | 20 | - | - | 5×10⁻⁴ | 100 | Example |
| 7 | 70 | (2) | 30 | - | - | 4×10⁻⁴ | 100 | Example |
| 8 | 90 | - | - | (A) | 10 | 3×10⁻³ | 100 | Comp. |
| 9 | 80 | - | - | (A) | 20 | 5×10⁻³ | 100 | Comp. |
| 10 | 70 | - | - | (A) | 30 | 6×10⁻³ | 100 | Comp. |
| 11 | 90 | - | - | (A) | 5 | 4×10⁻³ | 100 | Comp. |
| | | | | (B) | 5 | | | |
| 12 | 80 | - | - | (A) | 10 | 5×10⁻³ | 100 | Comp. |
| | | | | (B) | 10 | | | |
| 13 | 70 | - | - | (A) | 15 | 7×10⁻³ | 100 | Comp. |
| | | | | (B) | 15 | | | |
| 14 | 80 | (2) | 20 | | - | 9×10⁻³ | 100 | Example |

The compounds in the above Table 1 are as follows.
Compound 1 (manufactured by Gelest, a mixture of meta compound and para compound); the ratio of the total weight of carbon atoms composing the cyclic carbon structures in the monomer to the weight of the monomer is equal to 21% by weight. 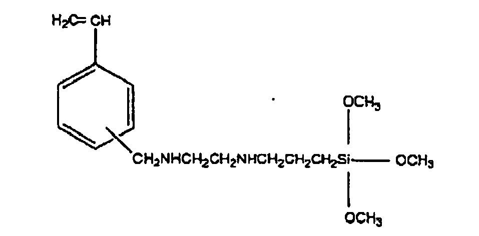 Compound 2 (manufactured by Gelest, a mixture of meta compound and para compound) ; the ratio of the total weight of carbon atoms composing the cyclic carbon structures in the monomer to the weight of the monomer is equal to 28% by weight. 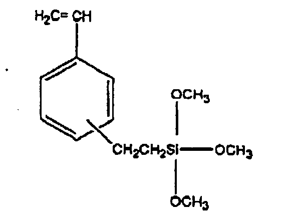 Compound A (manufactured by Shin-Etsu Chemical Co.,Ltd.) 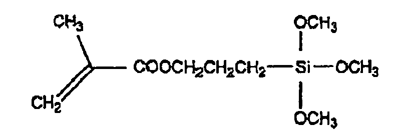 Compound B (manufactured by Wako Pure Chemical Industries, Ltd.)

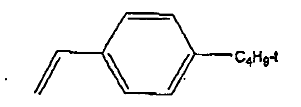

As is clear from the above results, it wad found that the compound in the present invention is excellent in its barrier property and adhesiveness. It was found that, when the comparative polymerizable compound (A), which has an ethylenic double bond and a group capable of causing a silane coupling reaction, but does not have an aromatic group, was used, the adhesiveness was improved but the barrier property is insufficient. It was found that, even when the monomer having an aromatic group is added in addition to the comparative polymerizable compound (A), the barrier property was kept insufficient.

### [Evaluation in Organic EL Device]

In order to evaluate gas barrier property, an organic EL device in which vapor or oxygen causes dark spot was formed. An ITO film-having conductive glass substrate (surface resistivity, 10 Ω/square) was washed with 2-propanol, and then processed for UV ozone treatment for 10 minutes. On the substrate (anode), the following compound layers were formed in order by vapor deposition according to a vacuum vapor deposition method.

### (First Hole Transporting Layer)

Copper phthalocyanine: film thickness 10 nm.

### (Second Hole Transporting Layer)

N,N'-diphenyl-N,N'-dinaphthylbenzidine: film thickness 40 nm.

### (Light-Emitting Layer also serving as electron transporting layer)

Tris(8-hydroxyquinolinato)aluminium: film thickness 60 nm.

### (Electron Injection Layer)

Lithium fluoride: film thickness 1 nm.

A metal aluminium was formed on it through vapor deposition to form a cathode having a thickness of 100 nm, and a silicon nitride film having a thickness of 3 µm was formed thereon according to a parallel plate CVD method, thereby constructing an organic EL device.

Next, using a thermosetting adhesive (Epotec 310, by Daizo-Nichimori), the gas barrier films formed above and the organic EL device were stuck together in such a manner that the side of the barrier layer could be on the side of the organic EL device, and heated at 65°C for 3 hours to cure the adhesive. 20 test pieces of every sample of the thus-sealed organic EL device were prepared.

Just after produced, the organic EL device was tested for light emission under application of 7 V thereto, using a source measure unit (SMU2400 Model by Keithley). Using a microscope, the light-emitting surface was observed, which confirmed uniform light emission by every device with no dark spot.

Finally, the devices were stored in a dark room at 60°C and 90% RH for 24 hours, and then tested for light emission. The proportion of the test pieces that gave dark spots larger than 300 µm in diameter is defined as a failure rate. The failure rate of every sample was computed. The devices of the present invention were the failure rate of 5% or below, and were good.

### Industrial applicability

Since the gas barrier film of the present invent invention has the high barrier property, it is possible to use widely for various devices in which its barrier property is desired. Since the organic layer in the gas barrier film of the present invention makes it possible to enhance the smoothness of the organic layer, the inorganic layer having a smooth surface is able to be provided. As the result, the present invention makes it possible to enhance the smoothness of the outermost surface, thereby enhancing properties of devices which are provided on the gas barrier film.

## Claims

1. A barrier laminate comprising at least one organic layer and at least one inorganic layer, wherein the organic layer is obtainable by curing a composition comprising a (meth)acrylate compound and a polymerizable compound represented by the following Formula (I): 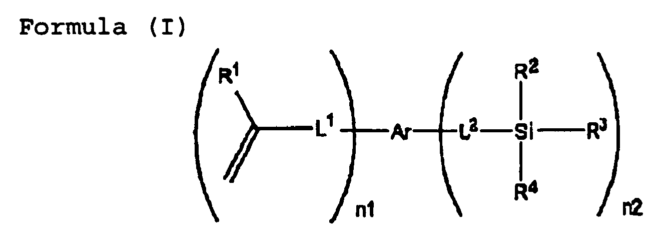 wherein Ar represents an optionally substituted aromatic group, R¹ represents a hydrogen atom, an alkyl group, a halogen atom, an alkoxy group, or an acyloxy group, L¹ and L² each represents an optionally substituted divalent linking group, R² and R³ each represents an alkoxy group, an acyloxy group, a halogen atom, or an amino group, R⁴ represents an alkyl group, an aryl group, an alkoxy group, an acyloxy group, a halogen atom, or an amino group, and n1 and n2 each represents an integer of 1 to 5; or
one of the following polymerizable compounds: 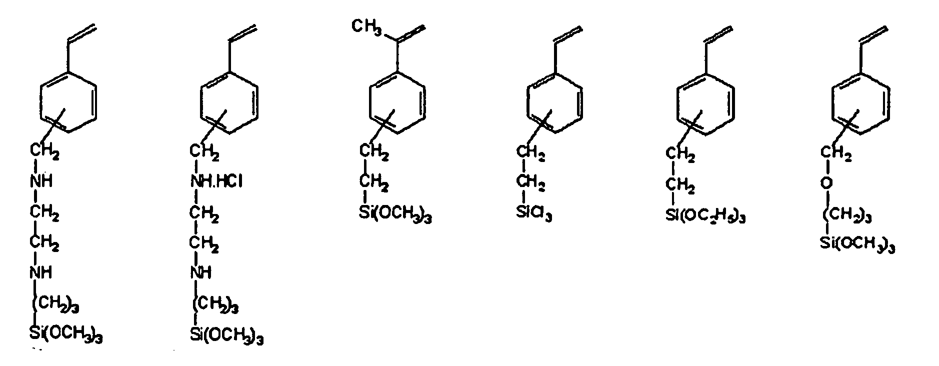 and
the weight of carbon atoms composing a cyclic carbon structure in the polymerizable compounds in the curable composition is ≥20% of the weight of polymerizable compounds in the curable composition.

2. A barrier laminate according to Claim 1, wherein Ar is a phenylene group, or a naphthalene group, L¹ and L² each represents an alkylene group, an arylene group, an ether group, an imino group, a carbonyl group, a sulfonyl group, or a bivalent residue formed by bonding a plurality thereof in series, and n1 and n2 are each 1 or 2.

3. A barrier laminate according to Claim 1 or Claim 2
, wherein the inorganic layer is on a surface of the organic layer.

4. A barrier laminate according to any preceding claim, wherein the inorganic layer comprises a metal oxide, a metal nitride, a metal carbide, a metal oxide-nitride or a metal oxide-carbide.

5. A barrier laminate according to Claim 4, wherein the inorganic layer comprises a metal oxide, a metal nitride, or a metal oxide-nitride.

6. A barrier laminate according to any preceding claim, wherein the inorganic layer comprises oxides comprising at least one of silicon and aluminium.

7. A barrier laminate according to any preceding claim, wherein the laminate comprises one of the organic layer and one of the inorganic layer.

8. A barrier laminate according to any of Claims 1-6, wherein the laminate comprises at least two of the organic layer and at least two of the inorganic layer laminated alternately.

9. A gas barrier film comprising a barrier laminate according to any preceding claim.

10. A device comprising a barrier laminate according to any of Claims 1-8.

11. As device according to Claim 10, wherein the device comprises a barrier film substrate which comprises the barrier laminate on a substrate film.

12. A device according to Claim 10 or Claim 11, wherein the device is sealed with the barrier laminate or the barrier film substrate.

13. A device according to any of Claims 10-12, wherein the device is an electronic device.

14. A device according to any of Claims 10-12, wherein the device is an organic electroluminescent device.

## Patentansprüche

1. Sperrlaminat, umfassend mindestens eine organische Schicht und mindestens eine anorganische Schicht, worin die organische Schicht durch Härten einer Zusammensetzung erhältlich ist, umfassend eine (Meth)acrylatverbindung und eine polymerisierbare Verbindung, dargestellt durch die folgende Formel (I): 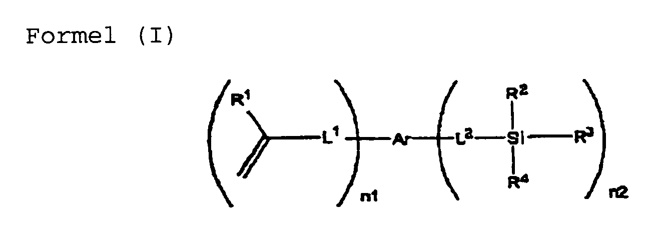 worin Ar eine optional substituierte aromatische Gruppe darstellt, R¹ ein Wasserstoffatom, eine Alkylgruppe, ein Halogenatom, eine Alkoxygruppe oder eine Acyloxygruppe darstellt, L¹ und L² jeweils eine optional substituierte, divalente Verknüpfungsgruppe darstellen, R² und R³ jeweils eine Alkoxygruppe, eine Acyloxygruppe, ein Halogenatom oder eine Aminogruppe darstellen, R⁴ eine Alkylgruppe, eine Arylgruppe, eine Alkoxygruppe, eine Acyloxygruppe, ein Halogenatom oder eine Aminogruppe darstellt, und n1 und n2 jeweils eine ganze Zahl von 1 bis 5 darstellen; oder
eine der folgenden polymerisierbaren Verbindungen: 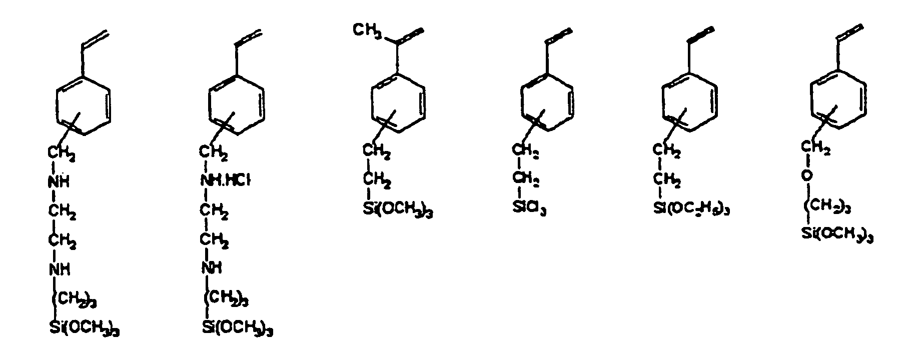 und
worin das Gewicht der Kohlenstoffatome, die eine cyclische Kohlenstoffstruktur in den polymerisierbaren Verbindungen in der härtbaren Zusammensetzung aufbauen, ≥ 20 % des Gewichts der polymerisierbaren Verbindungen in der härtbaren Zusammensetzung beträgt.

2. Sperrlaminat gemäß Anspruch 1, worin Ar eine Phenylengruppe oder eine Naphthalingruppe ist, L¹ und L² jeweils eine Alkylengruppe, eine Arylengruppe, eine Ethergruppe, eine Iminogruppe, eine Carbonylgruppe, eine Sulfonylgruppe oder einen bivalenten Rest, gebildet durch Verbinden einer Vielzahl hiervon in Serie, darstellen und n1 und n2 jeweils 1 oder 2 sind.

3. Sperrlaminat gemäß Anspruch 1 oder Anspruch 2, worin die anorganische Schicht auf einer Oberfläche der organischen Schicht vorliegt.

4. Sperrlaminat gemäß irgendeinem vorhergehenden Anspruch, worin die anorganische Schicht ein Metalloxid, ein Metallnitrid, ein Metallcarbid, ein Metalloxid-Nitrid oder ein Metalloxid-Carbid umfasst.

5. Sperrlaminat gemäß Anspruch 4, worin die anorganische Schicht ein Metalloxid, ein Metallnitrid oder ein Metalloxid-Nitrid umfasst.

6. Sperrlaminat gemäß irgendeinem vorhergehenden Anspruch, worin die anorganische Schicht Oxide umfasst, die mindestens eines von Silicium und Aluminium umfassen.

7. Sperrlaminat gemäß irgendeinem vorhergehenden Anspruch, worin das Laminat eine organische Schicht und eine anorganische Schicht umfasst.

8. Sperrlaminat gemäß irgendeinem der Ansprüche 1 bis 6, worin das Laminat mindestens zwei organische Schichten und mindestens zwei anorganische Schichten, die abwechselnd laminiert sind, umfasst.

9. Gassperrfolie, umfassend ein Sperrlaminat gemäß irgendeinem vorhergehenden Anspruch.

10. Vorrichtung, umfassend ein Sperrlaminat gemäß irgendeinem der Ansprüche 1 bis 8.

11. Vorrichtung gemäß Anspruch 10, worin die Vorrichtung ein Sperrfoliensubstrat umfasst, welches das Sperrlaminat auf einer Substratfolie bzw. einem Substratfilm umfasst.

12. Vorrichtung gemäß Anspruch 10 oder Anspruch 11, worin die Vorrichtung mit dem Sperrlaminat oder dem Sperrfoliensubstrat verschlossen ist.

13. Vorrichtung gemäß irgendeinem der Ansprüche 10 bis 12, worin die Vorrichtung eine elektronische Vorrichtung ist.

14. Vorrichtung gemäß gemäß irgendeinem der Ansprüche 10 bis 12, worin die Vorrichtung eine organische Elektrolumineszenzvorrichtung ist.

## Revendications

1. Stratifié formant barrière comprenant au moins une couche organique et au moins une couche inorganique dans lequel la couche organique peut être obtenue en faisant durcir une composition comprenant un composé de (méth)acrylate et un composé polymérisable représenté par la formule suivante (I) : 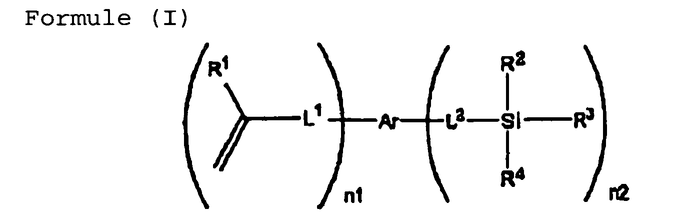 dans laquelle Ar représente un groupe aromatique substitué optionnellement, R¹ représente un atome d'hydrogène, un groupe alkyle, un atome d'halogène, un groupe alcoxy ou un groupe acyloxy, L¹ et L² représentent chacun un groupe de liaison divalent substitué optionnellement, R² et R³ représentent chacun un groupe alcoxy, un groupe acyloxy, un atome d'halogène ou un groupe amino, R⁴ représente un groupe alkyle, un groupe aryle, un groupe alcoxy, un groupe acyloxy, un atome d'halogène ou un groupe amino, et n1 et n2 représentent chacun un entier de 1 à 5 ; ou
un des composés polymérisables suivants : 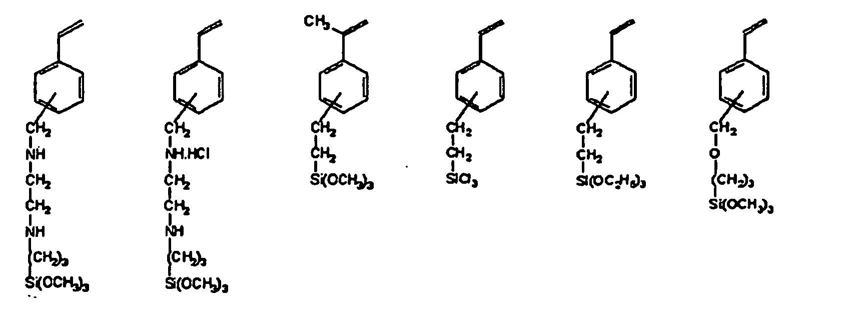 et
le poids d'atomes de carbone composant une structure carbonique cyclique dans les composés polymérisables dans la composition durcissable est ≥ 20 % du poids de composés polymérisables dans la composition durcissable.

2. Stratifié formant barrière selon la revendication 1, dans lequel Ar est un groupe phénylène ou un groupe naphthalène, L¹ et L² représentent chacun un groupe alkylène, un groupe arylène, un groupe éther, un groupe imino, un groupe carbonyle, un groupe sulfonyle ou un résidu bivalent formé par la liaison d'une pluralité de ceux-ci en série, et n1 et n2 sont chacun 1 ou 2.

3. Stratifié formant barrière selon la revendication 1 ou la revendication 2, dans lequel la couche inorganique est sur une surface de la couche organique.

4. Stratifié formant barrière selon l'une quelconque des revendications précédentes, dans lequel la couche inorganique comprend un oxyde de métal, un nitrure de métal, un carbure de métal, un nitrure - oxyde de métal ou un carbure - oxyde de métal.

5. Stratifié formant barrière selon la revendication 4, dans lequel la couche inorganique comprend un oxyde de métal, un nitrure de métal ou un nitrure - oxyde de métal.

6. Stratifié formant barrière selon l'une quelconque des revendications précédentes, dans lequel la couche inorganique comprend des oxydes comprenant au moins l'un de silicium et d'aluminium.

7. Stratifié formant barrière selon l'une quelconque des revendications précédentes, dans lequel le stratifié comprend une de la couche organique et une de la couche inorganique.

8. Stratifié formant barrière selon l'une quelconque des revendications 1 à 6, dans lequel le stratifié comprend au moins deux de la couche organique et au moins deux de la couche inorganique stratifiées en alternance.

9. Film formant barrière contre des gaz comprenant un stratifié formant barrière selon l'une quelconque des revendications précédentes.

10. Dispositif comprenant un stratifié formant barrière selon l'une quelconque des revendications 1 à 8.

11. Dispositif selon la revendication 10, dans lequel le dispositif comprend un substrat de film formant barrière qui comprend le stratifié formant barrière sur un film de substrat.

12. Dispositif selon la revendication 10 ou la revendication 11, dans lequel le dispositif est scellé avec le stratifié formant barrière ou le substrat de film formant barrière.

13. Dispositif selon l'une quelconque des revendications 10 à 12, dans lequel le dispositif est un dispositif électronique.

14. Dispositif selon l'une quelconque des revendications 10 à 12, dans lequel le dispositif est un dispositif électroluminescent organique.
